# EUROPEAN PATENT APPLICATION

(11) **EP 0 749 009 A1**
(43) Date of publication of application: **18.12.1996**
(21) Application number: 95913323.2
(22) Date of filing: 23.03.1995
(51) Int. Cl.: G01N 13/00

(54) **SOLDER WETTABILITY MEASURING INSTRUMENT**

(30) Priority: 28.12.1994 JP 340312/94
(71) Applicant: Nihon Almit Co.,Ltd., Tokyo 164 (JP)
(72) Inventor: KAWAGUCHI, Toranosuke Nihon Almit Co., Ltd., Nakano-ku Tokyo 164 (JP); KOJIMA, Mitsuo Nihon Almit Co., Ltd., Nakano-ku Tokyo 164 (JP)
(74) Representative: Casalonga, Axel
(86) International application number: JP9500532
(87) International publication number: WO9620398

(57) **Abstract**

The purpose of the present invention is to propose an apparatus for measuring wetness property of solder with very excellent measurement sensitivity.

The apparatus for measuring wetness property of solder according to the present invention is characterized in that it comprises a differential transformer which is fixed, a balance which is supported by a balancing fulcrum, a metallic test piece which hangs from the detection element of said differential transformer through an end of said balance, a counterweight which hangs from the other end of said balance, a solder tank which is filled with molten solder, a vertical movement apparatus which moves up and down said solder tank, a contact detection circuit which produces an output signal when said metallic test piece comes into contact with said molten solder in said solder tank, and a data processing apparatus which gains the wet depth of said metallic test piece into said molten solder and the wetting speed by using the output signal from said contact detection circuit as a trigger and which indicates them.

## Description

### Technical Field

The present invention relates to an apparatus for measuring wetness property of solder.

### Background Technology

As for a conventional apparatus for measuring wetness property of solder, such an apparatus in which a metallic test piece hangs from a spring as disclosed in Japanese Patent Publication No.33214/1984 titled 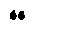 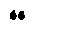 process and apparatus for testing soldered joint" is known.

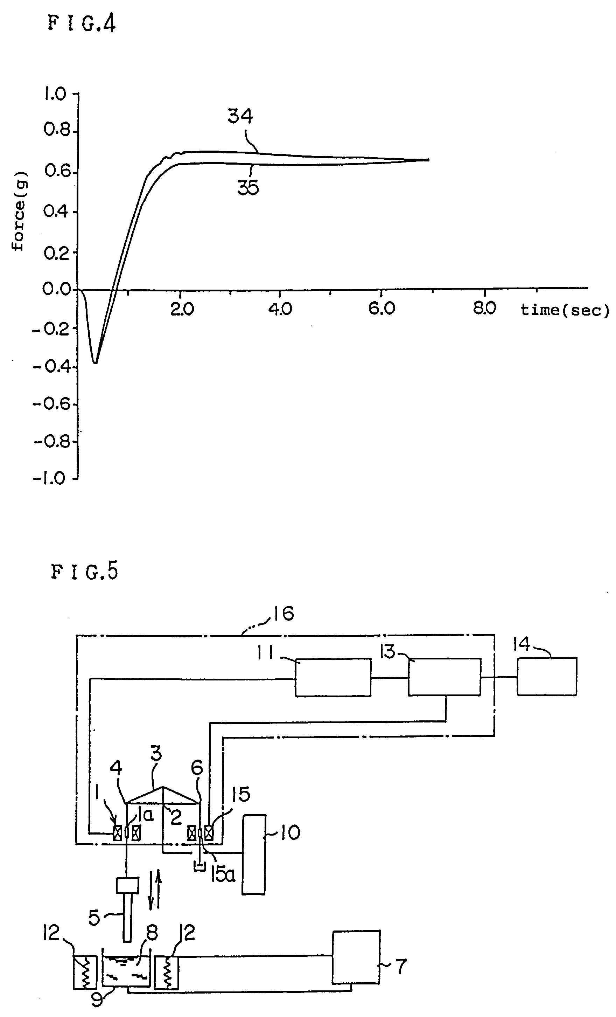

An apparatus for measuring wetness property of solder in which a metallic test piece hangs from an end of a balance is also used. This balance type apparatus for measuring wetness property of solder comprises a differential transformer 1 which is fixed, a balance 3 which is supported at a balancing fulcrum 2, a metallic test piece which hangs from an end 4 of the balance 3 through an detection element 1a comprising a magnet of the differential transformer 1, a magnet 15a which hangs from the other end 6 of the balance 3, a fixed coil 15 through which the magnet 15a moves up and down, a solder tank 9 which is filled with molten solder 8, a vertical movement device 10 which moves up and down a balancing apparatus 16 comprising a balance 3, a buoyancy detection circuit 11 and a control and indication circuit 13, a contact detection circuit, not shown, which produces an output signal when the metallic test piece 5 comes into contact with the molten solder 8 in the solder tank 9, a buoyancy detection circuit 11 which detects a displacement detected by the differential transformer 1 when the test piece 11 dips into the molten solder 8 in the solder tank 9 and moves vertically, a control and indication circuit 13 which gains the dip depth of the metallic test piece 5 into the molten solder 8 and the wetting speed based on the output signal from the contact detection circuit and the buoyancy detection circuit 11, and a recorder 14, as shown in Fig.5. The molten solder 8 in the solder tank 9 is heated properly by a heater 12 controlled by a temperature control circuit 7.

When a buoyancy or a wetness force is added to a metallic test piece 5 which hangs from an end of the balance, very small voltage is generated in the differential transformer 1 and amplified causing the occurrence of current in a coil 15. As a result, a balancing force which is the same magnitude with the force added to the metallic test piece 5 but in the reverse direction is generated between the coil 15 and the magnet 15a and the balance 3 is kept in a balancing condition. This balancing force is exactly proportional to the current in the coil 15. Therefore the balancing force added to the metallic test piece 5 can be detected by reading the current.

There is a problem that the measurement sensitivity of the former conventional example in which a test piece hangs from a spring is lower than that of the latter conventional example of electronic balance type for its structural reason.

On the other hand, in the latter conventional example, a balancing force which is the same magnitude with the force added to the metallic test piece 5 but in the reverse direction is generated between the coil 15 and the magnet 15a, the balance 3 is kept in a balancing condition and the balancing force added to the metallic test piece 5 can be detected by reading the current, as described above. Therefore this constitution necessitates electric control to the balance 3 and its measurement sensitivity is still insufficient. This is also a problem.

Hence the purpose of the present invention is to propose an apparatus for measuring wetness property of solder with very high measurement sensitivity.

### Disclosure of Invention

The apparatus for measuring wetness property of solder according to the present invention is characterized in that it comprises
a differential transformer which is fixed,
a balance which is supported by a balancing fulcrum,
a metallic test piece which hangs from a detection element of said differential transformer through an end of said balance,
a counterweight which hangs from the other end of said balance,
a solder tank which is filled with molten solder,
a vertical movement apparatus which moves up and down said solder tank,
a contact detection circuit which produces an output signal when said metallic test piece comes into contact with said molten solder in said solder tank, and
a data processing apparatus which gains the wet depth of said metallic test piece into said molten solder and the wetting speed by using the output signal from said contact detection circuit as a trigger and which indicates them.

According to the present invention, as a counterweight hangs from the other end of the balance and the vertical movement of the metallic test piece is detected through the vertical movement of the detection element of the differential transformer without such electric control as the conventional balance shown in Fig.5, the measurement sensitivity is raised remarkably.

The effects of the present invention are that the measurement sensitivity is very high as described above and that the circuit constitution is comparatively simple resulting in low cost as the balance is not controlled electrically.

### Simple Description of Drawings

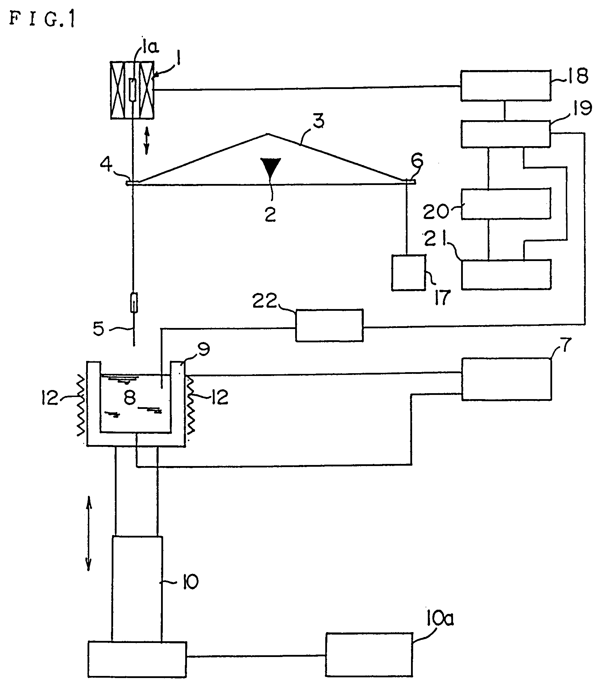

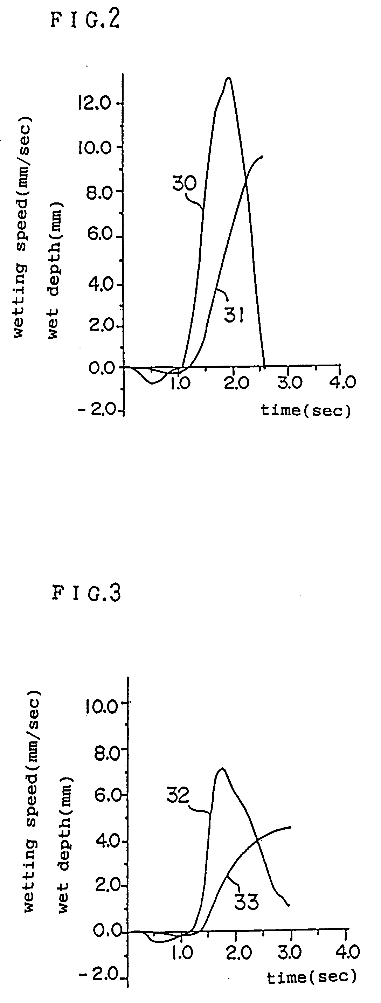

Fig.1 shows the circuit constitution of an embodiment of the present invention. Fig.2 is a graph showing the wetness characteristic of molten solder for an embodiment of the present invention. Fig.3 is a graph showing the wetness characteristic of molten solder for another embodiment of the present invention. Fig.4 is a graph showing the wetness characteristic of molten solder for a conventional example. Fig.5 shows the circuit constitution of a conventional example.

### Condition for Working the Invention

We describe the present invention below based on its embodiments referring to the drawings.

Fig.1. shows the circuit constitution of an embodiment of the present invention. A differential transformer 1 is fixed and a balance 3 is supported by a balancing fulcrum 2. A metallic test piece 5 hangs from the detection element 1a of the differential transformer 1 through an end 4 of the balance 3. A counter weight 17 hangs from the other end 6 of the balance 3. A solder tank 9 is filled with molten solder 8. A vertical movement apparatus 10 has a controller 10a by which the vertical movement of the solder tank 9 is controlled. A contact detection circuit 22 is a circuit which produces an output signal when the metallic test piece 5 comes into contact with the molten solder 8 in the solder tank 9.

A data processing apparatus is an apparatus which gains the wet depth of the metallic test piece 5 into the molten solder 8 and the wetting speed by using the output signal from the contact detection circuit 14 as a trigger and which indicates them, and comprises a displacement detection circuit 18, memory circuit 19, a differentiation circuit 20 and a recorder 21. A displacement detection circuit 18 is a circuit which detects the displacement detected by the differential transformer 1 when the metallic test piece 5 moves vertically dipping into the molten solder 8 in the solder tank 9. A memory circuit 19 is a circuit which memorizes the output signal from the displacement detection circuit 18. A differentiation circuit 20 is a circuit which differentiates the output signal from the memory circuit 19. A recorder 21 is an apparatus which indicates the wet depth of the metallic test piece 5 into the molten solder 8 and the wetting speed by plotting the data memorized by the memory circuit 19 through the output signal from the memory circuit 19 and the output signal from the differentiation circuit 20.

In this case, instead of using the memory circuit 19, the output signal from the displacement detection circuit 18 may be sent to a differentiation circuit 20 and a recorder 21 to plot data at real time and whereby to gain and indicate the wet depth of the metallic test piece 5 into the molten solder 8 and the wetting speed. The data processing apparatus is not limited to the above-mentioned constitution and includes the whole apparatus to gain the wet depth of the metallic test piece 5 into the molten solder 8 and the wetting speed by using the output signal from the contact detection circuit 14 as a trigger and to indicate them.

Curves 34 and 35 shown in Fig.4 indicate the detected buoyancies representing the wetting properties of two kinds of molten solders 8 with different fluxes in them respectively for a conventional example shown in Fig.5. As clarified from these curves 34 and 35, It is difficult to draw a sharp line between both kinds and the vertical relation between these curves 34 and 35 is reversed as the case may be, and it comes to the conclusion that the measurement sensitivity for this method is not so good.

On the other hand, curves shown in Fig.2 and Fig.3 indicate the wetting properties of two kinds of molten solders 8 with different fluxes in them respectively for an embodiment of the present invention.

In Fig.2, curves 31 and 30 show the wet depth (mm) of a kind of molten solder 8 and the wetting speed (mm/sec) gained through the differentiation of this wet depth (mm) by a differentiation circuit 20 respectively.

In Fig.3, curves 33 and 32 show the wet depth (mm) of the other kind of molten solder 8 and the wetting speed (mm/sec) gained through the differentiation of this wet depth by the differentiation circuit 20 respectively. The difference between the curves 30, 31 shown in Fig.2 and the curves 32, 33 shown in Fig. 3 is definite, and comes to the conclusion that very excellent measurement sensitively for the present invention is certified.

The above-mentioned data processing apparatus may also comprise a computer with an A/D conversion circuit.

In this case, the metallic test piece 5 may hang from an end 4 of the balance 3 through the detection element 1a of the differential transformer 1 instead of hanging from the detection element 1a of the transformer through an end 4 of balance 3.

Furthermore, a vertical movement apparatus which moves up and down the balance 3 may be used instead of the vertical movement apparatus 10 which moves up and down the solder tank 9.

## Claims

1. An apparatus for measuring wetness property of solder characterized in that it comprises
a differential transformer which is fixed,
a balance which is supported by a balancing fulcrum,
a metallic test piece which hangs from a detection element of said differential transformer through an end of said balance,
a counterweight which hangs from the other end of said balance,
a solder tank which is filled with molten solder,
a vertical movement apparatus which moves up and down said solder tank,
a contact detection circuit which produces an output signal when said metallic test piece comes into contact with said molten solder of said solder tank, and
a data processing apparatus which gains the wet depth of said metallic test piece into said molten solder and the wetting speed by using the output signal from said contact detection circuit as a trigger and which indicates them.

2. An apparatus for measuring wetness property of solder as claimed in claim 1 wherein said data processing apparatus comprises
a displacement detection circuit which detects the displacement detected in said differential transformer when said metallic test piece dips into said molten solder in said solder tank and moves vertically, by using the output signal from said contact detection circuit as a trigger,
a memory circuit which memorizes the output signal from said displacement detection circuit,
a differentiation circuit which differentiates the output signal from said memory circuit, and
a recorder which indicates the wet depth of said metallic test piece into said molten solder and the wetting speed by plotting data memorized by said memory circuit using the output signal from said memory circuit and the output signal from said differentiation circuit.

3. An apparatus for measuring wetness property of solder as claimed in claim 1 wherein said data processing apparatus comprises
a displacement detection circuit which detects the displacement detected in said differential transformer when said metallic test piece dips into said molten solder in said solder tank and moves vertically, by using the output signal from said contact detection circuit as a trigger,
a differentiation circuit which differentiates the output signal from said displacement detection circuit, and
a recorder which indicates the wet depth of said metallic test piece into said molten solder in said solder tank and the wetting speed by plotting data using the output signal from said differentiation circuit.

4. An apparatus for measuring wetness property of solder as claimed in claim 1 wherein said data processing apparatus comprises a computer with an A/D conversion circuit.

5. An apparatus for measuring wetness property of solder as claimed in any one of claims 1 to 4 wherein said metallic test piece hangs from an end of said balance through said detection element of said differential transformer instead of hanging from said detection element of said differential transformer through an end of said balance.

6. An apparatus for measuring wetness property of solder as claimed in any one of claims 1 to 5 wherein a vertical movement apparatus which move up and down said balance is used instead of a vertical movement apparatus which moves up and down said solder tank.
